# EUROPÄISCHE PATENTANMELDUNG

(11) **EP 1 267 487 A1**
(43) Veröffentlichungstag der Anmeldung: **18.12.2002**
(21) Anmeldenummer: 02007777.2
(22) Anmeldetag: 06.04.2002
(51) Int. Cl.: H03F 3/21, H03F 3/60

(54) **Hochfrequenzverstärker**

(30) Priorität: 15.06.2001 CH 10992001
(71) Anmelder: Contraves Space AG, 8052 Zürich (CH)
(72) Erfinder: Serbe, Christoph Peter, 8050 Zürich (CH); Ruzicka, Klaus, 8038 Zürich (CH)
(74) Vertreter: OK pat AG

(57) **Zusammenfassung**

Verstärkerschaltung (10) zum Verstärken eines hochfrequenten Eingangssignals (RF In), das an einem Eingang (11) angelegt und von dort einem Leistungsteiler (12) zugeführt wird. Der Leistungsteiler (12) ist derart mit dem Eingang (11) verknüpft, dass das hochfrequente Eingangssignal (RF In) in zwei Signalanteile RF1 und RF2 mit gleicher Leistung aufteilt wird. Die beiden Signalanteile RF1 und RF2 werden an den beiden Ausgängen (13) und (14) des Leistungsteilers (12) bereit gestellt. Auf den Leistungsteiler (12) folgt eine niederohmige Parallelschaltung (17) aus einem ersten Verstärkerblock (15), der mit dem Ausgang (13) des Leistungsteilers (12) verbunden ist, und einem zweiten Verstärkerblock (16), der mit dem zweiten Ausgang (14) des Leistungsteilers (12) verbunden ist. Der Haupttransistor (21) der Verstärkerschaltung (10) hat einen Eingang (22), der mit dem gemeinsamen Ausgang (20) der niederohmigen Parallelschaltung (17) verknüpft ist. Der Transistor (21) verstärkt das am Eingang des Transistors (21) anliegende Signal (RF4) und stellt am Ausgang (23) ein hochfrequentes Ausgangssignal (RF3) bereit, das gegenüber dem hochfrequenten Eingangssignal (RF In) verstärkt ist. Dabei wird die gesamte Anordnung vorzugsweise nicht in der Sättigung betrieben.

## Beschreibung

Die vorliegende Erfindung betrifft einen Verstärker zum Verstärken hochfrequenter Signale und eine Verwendung dieses Verstärkers. Derartige Verstärker sind insbesondere für den Einsatz in elektro-optischen Modulatoren geeignet.

Es gibt verschiedene Arten von Verstärkerschaltungen, die jedoch nur bedingt für den Einsatz im hochfrequenten Bereich geeignet sind. Verstärkerschaltungen, die für die Verstärkung niederfrequenter Signale geeignet sind können nicht einfach im Hochfrequenzbereich eingesetzt werden, da dort eigene Gesetzmässigkeiten gelten.

Hochfrequenzverstärker gemäss dem Stand der Technik werden typischerweise in der Sättigung betrieben. D.h. mit anderen Worten, die Transistoren dieser Hochfrequenzverstärker werden derart angesteuert, dass Sie im Sättigungsbereich oberhalb der Sättigungsspannung des Transistors arbeiten. Dabei erfolgt die Ansteuerung der Transistoren normalerweise in angepasster Weise, zum Beispiel mit einer sogenannten 50 Ohm Ansteuerung.

**Aufgabe** der Erfindung ist es daher,
- einen Verstärker mit hoher Bandbreite bereit zu stellen,
- einen Verstärker mit hoher Ausgangsleistung bereit zu stellen,
- einen Verstärker mit glatter Übertragungsfunktion bereit zu stellen,
- einen Verstärker bereit zu stellen, der obige Anforderungen erfüllt ohne in der Sättigung betrieben zu werden, und
- eine Verwendung derartiger Verstärker vorzuschlagen.

Die **Lösung** dieser Aufgabe erfolgt erfindungsgemäss
- für den Verstärker durch die Merkmale des Anspruchs **1**, und
- für deren Verwendung durch die Merkmale des Anspruchs **14**.

Vorteilhafte Weiterbildungen des Verstärkers werden durch die abhängigen Ansprüche **2** bis **13** definiert.

Gemäss der vorliegenden Erfindung ist die Verstärkerschaltung um einen Transistor (Haupttransistor) herum aufgebaut.

Es ist ein Vorteil der erfindungsgemässen Verstärkerschaltung, dass sie schnell ist, eine hohe Ausgangsleistung erzeugt und eine gute Übertragungseigenschaften (d.h. z.B. eine relativ glatte Übertragungsfunktion und eine hohe Bandbreite) hat. Der Haupttransistor wird dabei nicht in der Sättigung betrieben.

In einer vorteilhaften Ausführungsform hat die Verstärkerschaltung eine Ausgangsimpedanz von ca. 50 Ohm.

Die erfindungsgemässe Verstärkerschaltung ist sehr universell einsetzbar. Sie kann zum Beispiel in Mikrowellenanwendungen und anderen hochfrequenten Signalverarbeitungssystemen eingesetzt werden.

Weitere Eigenschaften und Vorteile der Erfindung werden im folgenden anhand der Beschreibung und mit Bezug auf die Zeichnung ausführlich beschrieben. Es zeigen:
- **Fig. 1**: eine erste Verstärkerschaltung gemäss der vorliegenden Erfindung;
- **Fig. 2**: eine zweite Verstärkerschaltung gemäss der vorliegenden Erfindung;
- **Fig. 3**: ein Versorgungsnetzwerk gemäss der vorliegenden Erfindung;
- **Fig. 4**: ein Rückkopplungsnetzwerk gemäss der vorliegenden Erfindung;
- **Fig. 5**: ein Leistungsteiler gemäss der vorliegenden Erfindung;
- **Fig. 6**: ein Kommunikationssystem mit einem elektro-optischen Modulator, gemäss der vorliegenden Erfindung.

### Detaillierte Beschreibung der Erfindung:

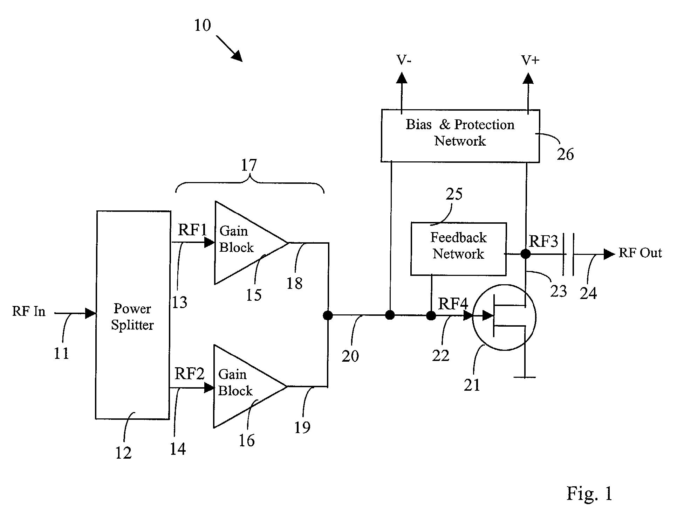

Das Wirkungsprinzip der vorliegenden Erfindung ist im Zusammenhang mit einem ersten Ausführungsbeispiel beschrieben. Dieses erste Ausführungsbeispiel ist in Figur 1 in Form eines schematischen Blockdiagramms dargestellt.

Die in Figur 1 gezeigte Verstärkerschaltung 10 ist zum Verstärken eines hochfrequenten Eingangssignals RF In geeignet. Das Eingangssignal RF In wird an einem Eingang 11 angelegt und von dort einem Leistungsteiler 12 zugeführt. Der Leistungsteiler 12 ist derart mit dem Eingang 11 verknüpft, dass das hochfrequente Eingangssignal RF In in zwei Signalanteile RF1 und RF2 mit gleicher Leistung aufteilt wird. Die beiden Signalanteile RF1 und RF2 werden an den beiden Ausgängen 13 und 14 des Leistungsteilers 12 bereit gestellt. Auf den Leistungsteiler 12 folgt eine niederohmigen Parallelschaltung 17 aus einem ersten Verstärkerblock 15, der mit dem Ausgang 13 des Leistungsteilers 12 verbunden ist, und einem zweiten Verstärkerblock 16, der mit dem zweiten Ausgang 14 des Leistungsteilers 12 verbunden ist.

Der Ausgang 18 des ersten Verstärkerblocks 15 und der Ausgang 19 des zweiten Verstärkerblocks 16 ist zu einem gemeinsamen Ausgang 20 der niederohmigen Parallelschaltung 17 zusammengeführt. Der Haupttransistor 21 der Verstärkerschaltung 10 hat einen Eingang 22 (Gate), der mit dem gemeinsamen Ausgang 20 der niederohmigen Parallelschaltung 17 verknüpft ist. Der Transistor 21 verstärkt das am Eingang des Transistors 21 anliegende Signal RF4 und stellt am Ausgang 23 (Drain) ein hochfrequentes Ausgangssignal RF3 bereit, das gegenüber dem hochfrequenten Eingangssignal RF In verstärkt ist.

In dem gezeigten Beispiel handelt es sich ei dem Haupttransistor 21 um einen n-Kanal Sperrschicht-Feldeffekt-Transistor (FET). Besonders geeignet sind z.B. FET-Transistoren für mittlere Leistung, vorzugsweise für Leistungen zwischen 250 mW und 3 W. Typischerweise haben Transistoren, die zum Einsatz im Zusammenhang mit der vorliegenden Erfindung geeignet sind eine Gatebreite zwischen 0,5 und 5 mm. Beispiele für besonders geeignete Transistoren sind: agilent AFT 44101, agilent AFT 45101, agilent AFT 46101, oder vergleichbare Typen.

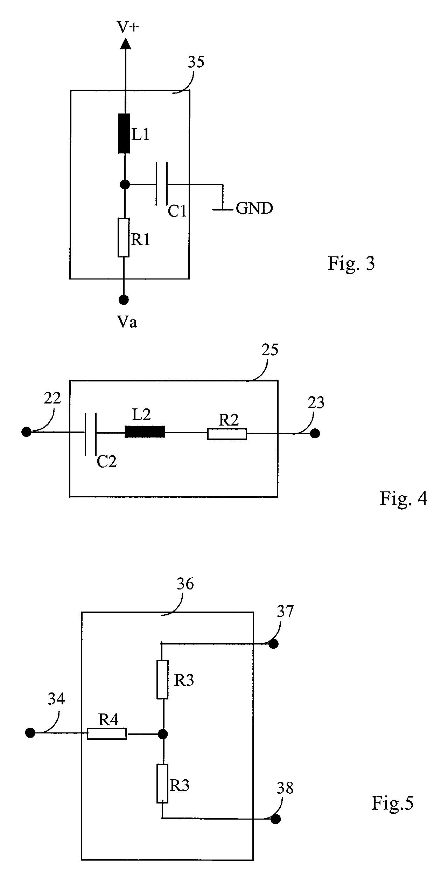

Zusätzlich zu den genannten Elementen kann die Verstärkerschaltung 10 ein Rückkopplungsnetzwerk 25 aufweisen, das den Ausgang 23 des Transistors 21 mit dessen Eingang 22 verbindet. Details eines möglichen Rückkopplungsnetzwerkes 25 sind in Figur 4 gezeigt. Das gezeigte Rückkopplungsnetzwerk 25 kann zum Beispiel eine Reihenschaltung aus einer Spule L2, einem Widerstandes R2 und einer Kapazität C2 umfassen.

Weiterhin kann der Arbeitspunkt des Transistors 21 über eine Arbeitspunktregelung 26 (Versorgungsnetzwerk) vorgegeben werden. Die Arbeitspunktregelung 26 kann auch, wie in Figur 1 gezeigt, ein Schutznetzwerk umfassen. Ein derartiges Schutznetzwerk weist vorzugsweise zwei entgegengesetzt-parallele Dioden auf, die mit dem Ausgang 23 des Transistors 21 verknüpft sind, um Signalspitzen, die am Ausgang 24 der Verstärkerschaltung 10 anliegen zu reduzieren. Diese Schutzschaltung ist vorzugsweise direkt mit dem Ausgang 23 des Transistors 21 verbunden.

Die Arbeitspunktregelung 26 sollte vorzugsweise so ausgelegt sein, dass der Transistor 21 im normalen Betrieb im linearen Bereich der Übertragungskennlinie betrieben wird.

In einer weiteren Ausführungsform der vorliegenden Erfindung ist die Verstärkerschaltung 10 derart beschaltet, dass sie eine Ausgangsimpedanz von 50 Ohm hat. Mit anderen Worten, der Ausgang 24 der Verstärkerschaltung 10 weist eine Anpassung von ungefähr 50 Ohm auf.

In einer vorteilhaften Ausführungsform sind die beiden Verstärkerblöcke 15 und 16 so dimensioniert, dass die niederohmige Parallelschaltung 17 eine Impedanz von weniger als 30 Ohm, vorzugsweise weniger als 20 Ohm aufweist. Durch die Parallelschaltung zweier Verstärkerblöcke wird die Impedanz zum Ansteuern des Haupttransistors gesenkt.

Man kann die Verstärkerschaltung so auslegen, dass der Ausgang 24 der Verstärkerschaltung 10 auf eine Induktivität arbeitet.

Für den Einsatz in Kommunikationssystemen ist es vorteilhaft, wenn die Verstärkerschaltung 10 derart dimensioniert ist, dass sie eine hohe Bandbreite aufweist. Dies kann man erreichen indem man z.B. ein Rückkopplungsnetzwerk 25 verwendet. Dadurch wird eine geringere Verstärkung aber eine höhere Bandbreite erzielt. Man kann auch eine Parallelschaltung eines Widerstandes und eines Kondensators im Signalpfad anordnen, um die Bandbreite zu verbessern.

In einer bevorzugten Ausführungsform der Erfindung sind der erste Verstärkerblock 15 und der zweite Verstärkerblock 16 symmetrisch ausgelegt. Zusätzlich kann man den ersten Verstärkerblock 15 und den zweiten Verstärkerblock 16 so realisieren, dass sie Reflektionen, die von dem Eingang 22 des Transistors 21 zurück in Richtung der beiden Verstärkerblöcke 15 und 16 laufen, unterdrücken. Dies kann man zum Beispiel erreichen, indem man stehende Wellen zwischen dem Eingang 11 und dem Eingang 22 des Transistors 21 unterdrückt. Diese Welligkeit würde sich negativ auf das Übertragungsverhalten der Verstärkerschaltung 10 auswirken.

Wenn man zum Beispiel Verstärkerblöcke 15 und 16 einsetzt, die je einen Verstärkungsfaktor A in Vorwärtsrichtung von A > 2 und vorzugsweise A > 10 haben, dann ergibt sich in Rückwärtsrichtung eine Dämpfung von 1/A, die ausreicht, um Reflektionen zu unterdrücken. Damit sieht man am Eingang 11 nichts mehr von der eigentlichen Fehlanpassung (Eingangsimpedanz kleiner als 50 Ohm) am Eingang 22 des Transistors 21.

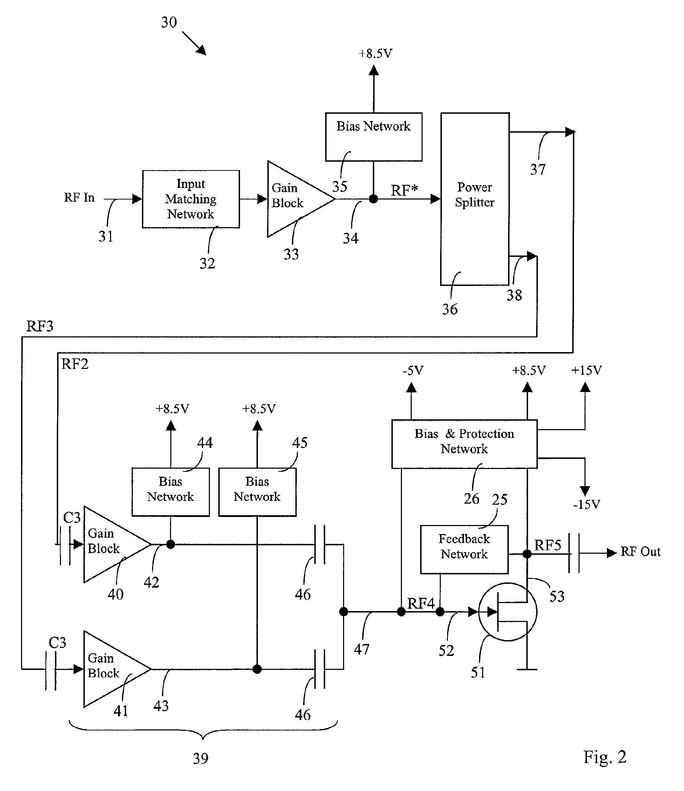

Eine weitere Ausführungsform der Erfindung ist in Figur 2 gezeigt. Die gezeigte Verstärkerschaltung 30 ist vom Aufbau her sehr ähnlich wie die in Figur 1 gezeigte Schaltung 10. Die Schaltung 30 weist die folgenden Bestandteile und Elemente auf. Am Eingang 31 RF In befindet sich ein Anpassungsnetzwerk 32 gefolgt von einem Eingangsverstärker 33. Der Ausgang 34 des Eingangsverstärkers 33 wird durch ein Arbeitspunktnetzwerk 35 auf einen geeigneten Arbeitspunkt (z.B Va) eingestellt und dann dem Eingang eines Leistungsteilers 36 zugeführt.

Der Leistungsteiler 36 ist derart mit dem Ausgang 34 des Eingangsverstärkers 33 verknüpft, dass das hochfrequente Eingangssignal RF* in zwei Signalanteile RF2 und RF3 mit gleicher Leistung aufteilt wird. Die beiden Signalanteile RF2 und RF3 werden an den beiden Ausgängen 37 und 38 des Leistungsteilers 36 bereit gestellt. Auf den Leistungsteiler 36 folgt eine niederohmigen Parallelschaltung 39 aus einem ersten Verstärkerblock 40, der mit dem Ausgang 37 des Leistungsteilers 36 verbunden ist, und einem zweiten Verstärkerblock 41, der mit dem zweiten Ausgang 38 des Leistungsteilers 36 verbunden ist. Die beiden Ausgänge 42 und 43 der Verstärkerblöcke 40 und 41 werde je durch ein Arbeitspunktnetzwerk 44 bzw. 45 auf einen geeigneten Arbeitspunkt eingestellt und dann über zwei Kapazitäten 46 zu einem gemeinsamen Ausgang 47 der niederohmigen Parallelschaltung 39 zusammengeführt.

Die Schaltung 30 weist einen Haupttransistor 51 auf, dessen Eingang 52 (Gate) mit dem gemeinsamen Ausgang 47 der niederohmigen Parallelschaltung 39 verknüpft ist. In der gezeigten Ausführungsform 30 ist der gemeinsamen Ausgang 47 direkt mit dem Eingang 52 (Gate) des Transistors 51 verknüpft.

In einer weiteren Ausführungsform kann diese Verknüpfung über ein RC-Glied erfolgen, das zwischen dem gemeinsamen Ausgang 47 und dem Eingang 52 (Gate) des Transistors 51 angeordnet ist. Dieses RC-Glied kann so dimensioniert werden, dass man den Frequenzgang korrigieren kann. Das RC-Glied kann zu diesem Zweck zum Beispiel aus einem Widerstand mit parallelgeschalteter Kapazität bestehen.

Der Transistor 51 verstärkt das am Eingang 52 des Transistors 51 anliegende Signal RF4 und stellt am Ausgang 53 (Drain) ein hochfrequentes Ausgangssignal RF5 bereit, das gegenüber dem hochfrequenten Eingangssignal RF In verstärkt ist.

Zusätzlich zu den genannten Elementen kann die Verstärkerschaltung 30 ein Rückkopplungsnetzwerk 25 aufweisen, das den Ausgang 53 des Transistors 51 mit dessen Eingang 52 verbindet.

Weiterhin kann der Arbeitspunkt des Transistors 51 über eine Arbeitspunktregelung 26 vorgegeben werden. Die Arbeitspunktregelung 26 kann zum Beispiel ein Schutznetzwerk umfassen, um am Ausgang 54 der Verstärkerschaltung 30 anliegende Signalspitzen zu reduzieren.

Die Arbeitspunktregelung 26 sollte vorzugsweise so ausgelegt sein, dass der Transistor 51 im normalen Betrieb im linearen Bereich der Übertragungskennlinie betrieben wird.

Die Arbeitspunktregelung (zum Beispiel Arbeitspunktregelung 35 in Figur 2) kann ein Versorgungsnetzwerk umfassen, das aus einer Kombination von konventionellen Bauteilen (z.B. Spulen, Kapazitäten und Widerständen) besteht. Typischerweise wird ein solches Versorgungsnetzwerk von einer Versorgungsspannung V+ (z.B. zwischen 5V und 20 V) gespeist, wie in Figur 3 gezeigt. Die Ausgangsspannung Va des Versorgungsnetzwerkes liegt zwischen der Versorgungsspannung V+ und 0V.

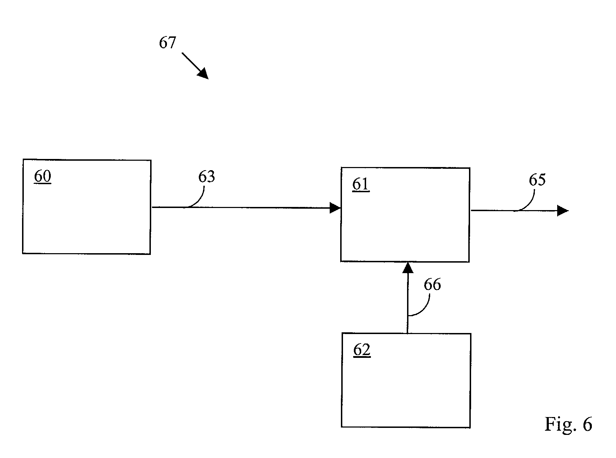

Vorzugsweise handelt es sich bei dem Leistungsteiler um eine resistiven Leistungsteiler, der in alle drei Richtungen (d.h. in Bezug auf den Eingang und die beiden Ausgänge) angepasst ist. Ein solcher Leistungsteiler 36 kann zum Beispiel aus einem Netzwerk mit mehreren Widerständen R3 und R4 aufgebaut sein, wie in Figur 5 gezeigt. Optional können die Kapazitäten C3 als Entkopplungs-Kondensatoren für die Gain-Blocks eingesetzt werden.

Man kann die erfindungsgemässe Verstärkerschaltung modifizieren, indem man eine niederohmig Parallelschaltung von mehr als zwei Verstärkerblöcken vorsieht, die den Haupttransistors ansteuern.

Bei der niederohmigen Ansteuerung des Haupttransistors handelt es sich im eigentlichen Sinne um eine bewusste Fehlansteuerung.

Die Verstärkerschaltung gemäss der vorliegenden Erfindung kann unter anderem als Komponente eines Übertragungssystems eingesetzt werden, insbesondere in einem Übertragungssystem mit faseroptischer Übertragungsstrecke.

Die Verstärkerschaltung kann vorteilhafterweise zum Ansteuern eines elektro-optischen Modulators eingesetzt werden, der moduliertes Licht aussendet. Das Licht wird durch ein elektrisches Signal moduliert, das die Verstärkerschaltung am Ausgang bereit stellt. Ein Beispiel einer entsprechenden Anordnung ist in Figur 6 gezeigt. Der elektro-optische Modulator 61 kann Bestandteil eines Kommunikationssystems 67 (z.B. ein Verstärker) sein, das ausser dem elektro-optischen Modulator 61 eine Lichtquelle 60 und eine Signalquelle 62 aufweist. Die Lichtquelle 60, z.B. ein continuous wave (CW) Laser, generiert eine Lichtwelle, die über eine Fiber 63 in den elektro-optischen Modulator 61 gespeist wird. Die Signalquelle 62 stellt ein hochfrequentes Signal bereit, das mittels einer erfindungsgemässen Verstärkerschaltung 10 oder 30 verstärkt und über eine Leitung 66 dem elektro-optischen Modulator 61 zugeführt wird. Der elektro-optische Modulator 61 moduliert die Lichtwelle mit dem verstärkten hochfrequenten Signal, um an einem Ausgang 65 eine modulierte Lichtwelle bereit zu stellt. Die modulierte Lichtwelle kann zum Beispiel in eine faseroptische Übertragungsstrecke eingespeist werden, oder für die optische Freiraumkommunikation, zum Beispiel zwischen Satelliten oder zwischen einem Satellit und einer Bodenstation, verwendet werden.

## Patentansprüche

1. Verstärkerschaltung (10, 30) zum Verstärken eines hochfrequenten Eingangssignals (RF In), mit
■ einem Eingang (11; 31) für das hochfrequente Eingangssignal (RF In),
■ einem Leistungsteiler (12; 36) der mit dem Eingang (11; 31) derart verknüpft ist und das hochfrequente Eingangssignal (RF In) in zwei Signalanteile mit gleicher Leistung aufteilt und an zwei Ausgängen (13, 14; 37, 38) des Leistungsteilers (12; 36) bereit stellt,
■ einem ersten Verstärkerblock (15; 40), der mit einem ersten der beiden Ausgänge (13; 37) des Leistungsteilers (12; 36) verbunden ist,
■ einem zweiten Verstärkerblock (16; 41), der mit dem zweiten der beiden Ausgänge (14; 38) des Leistungsteilers (12; 36) verbunden ist, wobei der erste Verstärkerblock (15; 40) und der zweite Verstärkerblock (16; 41) in einer niederohmigen Parallelschaltung (17; 39) angeordnet und der Ausgang (18; 42) des ersten Verstärkerblocks (15; 40) mit dem Ausgang (19; 43) des zweiten Verstärkerblocks (16; 41) zu einem gemeinsamen Ausgang (20; 47) zusammengeführt sind,
■ einem Transistor (21; 51), dessen Eingang (22; 52) mit dem gemeinsamen Ausgang (20; 47) verknüpft und durch die niederohmigen Parallelschaltung (17; 39) ansteuerbar ist und an einem Ausgang (23; 53) ein hochfrequentes Ausgangssignal (RF3) bereit stellt, das gegenüber dem hochfrequenten Eingangssignal (RF In) verstärkt ist.

2. Verstärkerschaltung (10; 30) nach Anspruch 1, wobei der Ausgang (23; 53) des Transistors (21; 51) derart beschaltet ist, dass die Verstärkerschaltung (10; 30) eine Ausgangsimpedanz von 50 Ohm hat.

3. Verstärkerschaltung (10; 30) nach Anspruch 1 oder 2, wobei die niederohmige Parallelschaltung (17) eine Impedanz von weniger als 30 Ohm, vorzugsweise weniger als 20 Ohm aufweist.

4. Verstärkerschaltung (10; 30) nach Anspruch 1, 2 oder 3, wobei der Ausgang (23; 53) des Transistors (21; 51) derart beschaltet ist, dass die Verstärkerschaltung (10; 30) auf eine Induktivität arbeitet.

5. Verstärkerschaltung (10; 30) nach einem der Ansprüche 1 bis 4, wobei der Transistor (21; 51) derart beschaltet ist, dass er im linearen Bereich betrieben ist.

6. Verstärkerschaltung (10; 30) nach einem der Ansprüche 1 bis 5, wobei die Verstärkerschaltung (10; 30) derart dimensioniert ist, dass der Ausgang (24; 54) der Verstärkerschaltung (10; 30) eine Anpassung von ungefähr 50 Ohm aufweist.

7. Verstärkerschaltung (10; 30) nach einem der Ansprüche 1 bis 6, wobei die Verstärkerschaltung (10; 30) derart dimensioniert ist, dass sie eine hohe Bandbreite aufweist.

8. Verstärkerschaltung (10; 30) nach einem der Ansprüche 1 bis 7, wobei der erste Verstärkerblock (15; 40) und der zweite Verstärkerblock (16; 41) symmetrisch ausgelegt sind.

9. Verstärkerschaltung (10; 30) nach einem der Ansprüche 1 bis 7, wobei der erste Verstärkerblock (15; 40) und der zweite Verstärkerblock (16; 41) derart ausgelegt sind, dass sie Reflektionen, die von dem Eingang (22; 52) des Transistors (21; 51) zurück in Richtung des ersten Verstärkerblocks (15; 40) und des zweiten Verstärkerblocks (16; 41) laufen, unterdrücken.

10. Verstärkerschaltung (10; 30) nach einem der Ansprüche 1 bis 7, wobei der erste Verstärkerblock (15; 40) und der zweite Verstärkerblock (16; 41) derart ausgelegt sind, dass stehende Wellen zwischen dem Eingang (11; 31) für das hochfrequente Eingangssignal (RF In) und dem Eingang (22; 52) des Transistors (21; 51) unterdrückt sind.

11. Verstärkerschaltung (10; 30) nach einem der Ansprüche 1 oder 2, wobei ein Schutznetzwerk, vorzugsweise aus zwei entgegengesetzt-parallelen Dioden, mit dem Ausgang (23; 53) des Transistors (21; 51) verknüpft ist, um am Ausgang (24; 54) der Verstärkerschaltung (10; 30) anliegende Signalspitzen zu reduzieren.

12. Verstärkerschaltung (10; 30) einem der vorhergehenden Ansprüche, wobei die Verstärkerschaltung (10; 30) als ein Treiber für einen elektro-optischen Modulator dimensioniert ist.

13. Verstärkerschaltung (10; 30) nach einem der Ansprüche 1 bis 7, wobei die Verstärkerschaltung (10; 30) derart dimensioniert ist, dass sie für das Verstärken eines Mikrowellen Eingangssignals (RF In) geeignet ist.

14. Verwendung einer Verstärkerschaltung (10; 30) nach einem der Ansprüche 1 - 13 in einem Kommunikationssystem (67), das einen Lichtquelle (60) einen elektro-optischen Modulator (61) und eine Signalquelle (62) aufweist, wobei
- die Lichtquelle (60) eine Lichtwelle über eine Fiber (63) in den elektro-optischen Modulator (61) speist,
- die Signalquelle (62) ein hochfrequentes Signal mittels der Verstärkerschaltung (10; 30) verstärkt und über eine Leitung (66) dem elektro-optischen Modulator (61) zuführt,
- der elektro-optischen Modulator (61) die Lichtwelle mit dem verstärkten hochfrequenten Signal moduliert und eine Lichtwelle an einem Ausgang (65) bereit stellt.
